# EUROPEAN PATENT APPLICATION

(11) **EP 4 719 016 A2**
(43) Date of publication of application: **01.04.2026**
(21) Application number: 25203566.2
(22) Date of filing: 22.09.2025
(51) Int. Cl.: H10K 59/131, G06F 3/041, G06F 3/045

(54) **TOUCH PANEL**

(30) Priority: 25.09.2024 JP 2024165970
(71) Applicant: FCL Components Limited, Tokyo 140-0002 (JP)
(72) Inventor: OZAWA, Takuya, Shinagawa-ku, 140-0002 (JP); UENO, Yutaka, Shinagawa-ku, 140-0002 (JP); HAGIHARA, Hideyuki, Shinagawa-ku, 140-0002 (JP); MORI, Wataru, Shinagawa-ku, 140-0002 (JP)
(74) Representative: Haseltine Lake Kempner LLP

(57) **Abstract**

Provided is a touch panel (100) having an operation region (1) for receiving operation input and a decoration region (2) for not receiving the operation input. The touch panel includes a first substrate (10) and a second substrate (20) that are arranged to face each other with a space therebetween, a plurality of connection terminals (21c to 24c) provided on a surface (20a) of the second substrate facing the first substrate, a wiring substrate (40) arranged in the decoration region and between the first substrate and the second substrate, the wiring substrate having a plurality of wiring patterns (43) electrically connected to the plurality of connection terminals, respectively, and at least one of a first dummy pattern (44) that is separated from the plurality of wiring patterns, is arranged between the plurality of wiring patterns, and has a thickness substantially the same as a thickness of each of the plurality of wiring patterns, and a second dummy pattern (27) that is separated from the plurality of connection terminals, is arranged between the plurality of connection terminals, and has a thickness substantially the same as a thickness of each of the plurality of connection terminals.

## Description

### FIELD

A certain aspect of the embodiments is related to a touch panel.

### BACKGROUND

Conventionally, there has been known a touch panel having a decoration region which does not accept an input operation. The decoration region is a non-operation region formed on the outer periphery of the touch panel and is a region for hiding electrode wiring and the like in the touch panel from the operator's line of sight. Further, there has been known a structure of a touch panel in which a flexible printed circuit (FPC) is connected to an outer peripheral portion of the touch panel. There has been known a clip for sandwiching the upper and lower substrates of a touch panel. Note that the technique related to the present disclosure is disclosed in Japanese Laid-Open Patent Publication No. 2012-208620, Japanese Laid-Open Patent Publication No. 2009-199249, Japanese Laid-Open Patent Publication No. 2015-026343, and Japanese Laid-Open Patent Publication No. 2001-092594.

### SUMMARY

When the flexible printed circuit (FPC) is sandwiched between the film substrate and the glass substrate of the touch panel, and thermocompression bonding is performed from above the film substrate, the film substrate is deformed, and traces of the wiring pattern of the FPC and connection terminals on the glass substrate may be attached to the film substrate. In particular, when a press-bonded portion of the FPC must be arranged in the decoration region, the film at the position of the press-bonded portion cannot be hidden by the housing or the like, and therefore, the appearance of the touch panel may be impaired by press-bonded marks.

The present disclosure provides a touch panel that can suppress the appearance from being deteriorated.

According to a first aspect of the present disclosure, there is provided a touch panel having an operation region for receiving operation input and a decoration region for not receiving the operation input. The touch panel includes: a first substrate and a second substrate that are arranged to face each other with a space therebetween; a plurality of connection terminals provided on a surface of the second substrate facing the first substrate; a wiring substrate arranged in the decoration region and between the first substrate and the second substrate, the wiring substrate having a plurality of wiring patterns electrically connected to the plurality of connection terminals, respectively; and at least one of a first dummy pattern that is separated from the plurality of wiring patterns, is arranged between the plurality of wiring patterns, and has a thickness substantially the same as a thickness of each of the plurality of wiring patterns, and a second dummy pattern that is separated from the plurality of connection terminals, is arranged between the plurality of connection terminals, and has a thickness substantially the same as a thickness of each of the plurality of connection terminals.

The touch panel further may include a reinforcing member provided between a surface of the first substrate facing the second substrate and the wiring substrate.

According to a second aspect of the present disclosure, there is provided a touch panel having an operation region for receiving operation input and a decoration region for not receiving the operation input. The touch panel includes: a first substrate and a second substrate that are arranged to face each other with a space therebetween; a plurality of connection terminals provided on a surface of the second substrate facing the first substrate; a wiring substrate arranged in the decoration region and between the first substrate and the second substrate, the wiring substrate having a plurality of wiring patterns electrically connected to the plurality of connection terminals, respectively. A conductive film is formed on the surface of the second substrate facing the first substrate, the plurality of connection terminals are formed in the decoration region and on the conductive film, the conductive film between the plurality of connection terminals is separated into a plurality of conductive films, and the plurality of wiring patterns are connected to the connection terminals through the plurality of conductive films, respectively.

The touch panel further may include a reinforcing member provided between a surface of the first substrate facing the second substrate and the wiring substrate.

According to a third aspect of the present disclosure, there is provided a touch panel having an operation region for receiving operation input and a decoration region for not receiving the operation input. The touch panel includes: a first substrate and a second substrate that are arranged to face each other with a space therebetween; a plurality of connection terminals provided on a surface of the second substrate facing the first substrate; and a wiring substrate arranged in the decoration region and on a surface of the second substrate opposite to the first substrate, the wiring substrate having a plurality of wiring patterns electrically connected to the plurality of connection terminals, respectively. Each of the plurality of connection terminals and the second substrate includes a through hole and a conductor inserted into the through hole, and each of the plurality of connection terminals is electrically connected to each of the plurality of wiring patterns through the conductor.

According to a fourth aspect of the present disclosure, there is provided a touch panel having an operation region for receiving operation input and a decoration region for not receiving the operation input. The touch panel includes: a first substrate and a second substrate that are arranged to face each other with a space therebetween; a plurality of connection terminals provided on a surface of the second substrate facing the first substrate; a wiring substrate arranged in the decoration region, the wiring substrate having a plurality of wiring patterns electrically connected to the plurality of connection terminals, respectively; and a conductor sandwiching one of the plurality of connection terminals, a part of the surface of the second substrate facing the first substrate, an end face of the second substrate, and a part of a surface of the second substrate opposite to the first substrate. The wiring substrate is arranged on a part of the conductor.

According to a fifth aspect of the present disclosure, there is provided a touch panel including: a first substrate and a second substrate that are arranged to face each other with a space therebetween; a plurality of connection terminals provided on a surface of the first substrate facing the second substrate; and a wiring substrate having a plurality of wiring patterns electrically connected to the plurality of connection terminals, respectively. The first substrate includes a main body facing the second substrate, and an extension portion that extends from the main body, is fixed to a housing, and is covered by the housing. The wiring substrate is arranged on the extension portion.

According to the aspects of the present disclosure, it is possible to suppress the appearance from being deteriorated.

### BRIEF DESCRIPTION OF DRAWINGS

FIG. 1A is an external view of a touch panel according to a present embodiment.
FIG. 1B is a configuration diagram of an upper substrate included in the touch panel of FIG. 1A viewed through from above.
FIG. 1C is a configuration diagram of a lower substrate included in the touch panel of FIG. 1A.
FIG. 1D is a transparent view of the touch panel of FIG. 1A viewed from above.
FIG. 2A is a cross-sectional view of the upper substrate taken along a line A-A in FIG. 1B.
FIG. 2B is a cross-sectional view of the lower substrate taken along a line B-B in FIG. 1C.
FIG. 2C is a cross-sectional view of the touch panel taken along a line C-C in FIG. 1D.
FIG. 3A is a diagram illustrating a state where an FPC is connected to connection terminals.
FIG. 3B is a configuration diagram of the FPC.
FIG. 4A is a configuration diagram of the vicinity of the connection terminals of a lower substrate.
FIG. 4B is a cross-sectional view taken along a line D-D of FIG. 4A.
FIG. 5 is a configuration diagram of a modification of the lower substrate in the vicinity of the connection terminals.
FIG. 6A is a cross-sectional view of a modification of the touch panel taken along a line C-C of FIG. 1D.
FIG. 6B is a cross-sectional view of a modification of the FPC.
FIG. 6C is a plan view of a base film of the FPC.
FIG. 7A is a configuration diagram of the vicinity of the connection terminals of the lower substrate.
FIG. 7B is a cross-sectional view of the touch panel taken along a line E-E of FIG. 7A.
FIG. 8A is a configuration diagram of the vicinity of the connection terminals of the lower substrate.
FIG. 8B is a cross-sectional view of the touch panel taken along a line F-F of FIG. 8A.
FIG. 9A is a configuration diagram of an upper substrate included in a touch panel according to a modification.
FIG. 9B is a configuration diagram of a lower substrate included in the touch panel according to the modification.
FIG. 9C is a cross-sectional view of a part of the touch panel according to the modification.

### DESCRIPTION OF EMBODIMENTS

Hereinafter, a description will be given of the embodiment of the present disclosure with reference to the drawings.

### [First Embodiment]

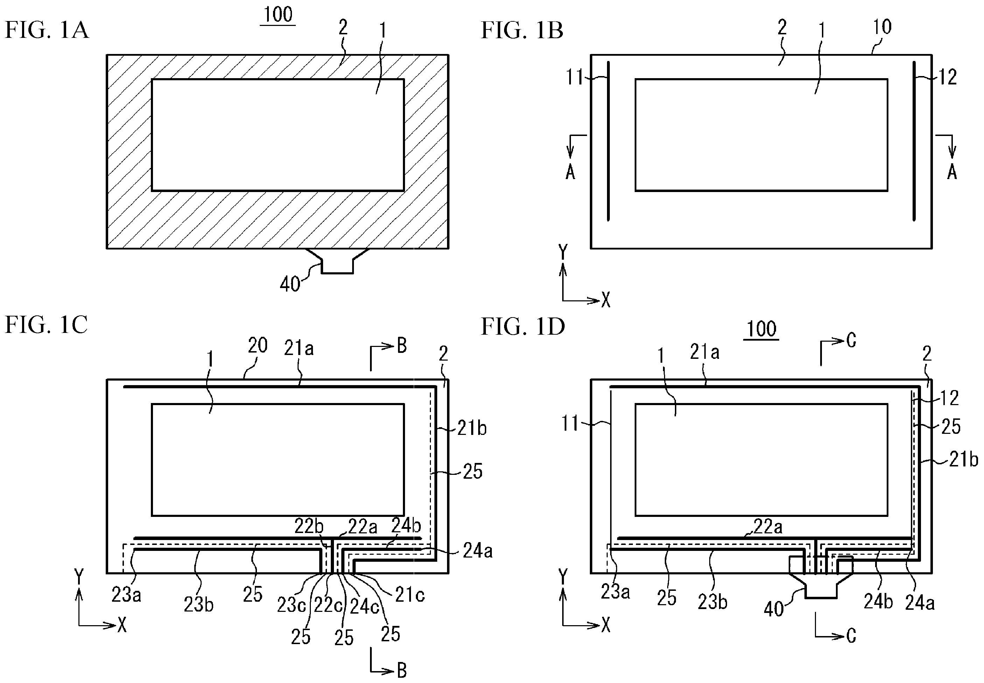

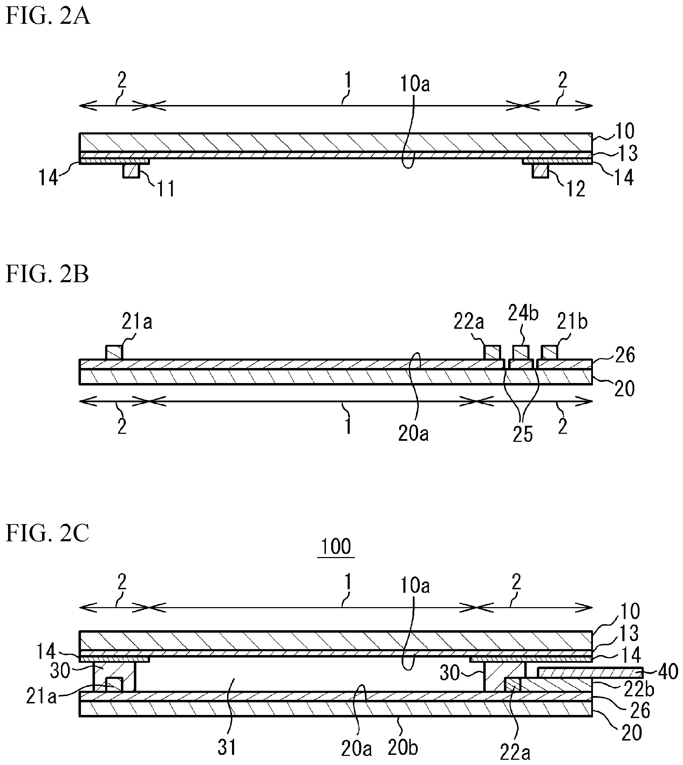

FIG. 1A is an external view of a touch panel according to a present embodiment. FIG. 1B is a configuration diagram of an upper substrate included in the touch panel of FIG. 1A viewed through from above. FIG. 1C is a configuration diagram of a lower substrate included in the touch panel of FIG. 1A. FIG. 1D is a transparent view of the touch panel of FIG. 1A viewed from above. FIG. 2A is a cross-sectional view of the upper substrate taken along a line A-A in FIG. 1B. FIG. 2B is a cross-sectional view of the lower substrate taken along a line B-B in FIG. 1C. FIG. 2C is a cross-sectional view of the touch panel taken along a line C-C in FIG. 1D.

A touch panel 100 according to the present embodiment is a resistive touch panel. The touch panel 100 is a four-wire type touch panel, but may be a five-wire type touch panel or a seven-wire type touch panel. As illustrated in FIG. 1A, the touch panel 100 has a transparent operation region 1 in the center of the touch panel 100 and an opaque decoration region 2 on the outer periphery of the operation region 1. The operation region 1 is a region for receiving an input operation by a finger, a pen, or the like. The decoration region 2 is a non-operation region which does not accept input operation by a finger or a pen, and is a region for hiding electric wiring patterns, spacers, and the like from the view of an operator. The touch panel 100 is mounted on a smartphone, a tablet terminal, or the like.

As illustrated in FIG. 2C, the touch panel 100 includes an upper substrate 10 (first substrate) and a lower substrate 20 (second substrate). An upper conductive film 13 is formed on a surface 10a of the upper substrate 10 facing the lower substrate 20, and a decoration layer 14 is formed at a position corresponding to the decoration region 2 of the upper conductive film 13. The upper conductive film 13 is made of indium tin oxide (ITO: Indium Tin Oxide) or the like. The upper substrate 10 is made of, for example, a PET film. The decoration layer 14 is made of a conductive material containing a light-shielding material, for example, a carbon-based ink. The decoration layer 14 is formed by ink jet printing, silk printing, or the like.

As illustrated in FIGs. 1B and 2A, a pair of electrodes 11 and 12 extending in the Y direction are formed in the decoration region 2 and on the decoration layer 14.

As illustrated in FIGs. 1C and 1D, a pair of electrodes 21a and 22a extending in the X direction are opposed to each other with the operation region 1 interposed therebetween, and are provided in the decoration region 2 of the lower substrate 20. Wirings 21b to 24b and connection terminals 21c to 24c are provided in the decoration region 2 of the lower substrate 20. The connection terminals 21c to 24c are terminals for electrically connecting to an FPC 40 (wiring substrate). The electrodes 11 and 12, the electrodes 21a and 22a, the wirings 21b to 24b, and the connection terminals 21c to 24c are made of a metal paste such as copper or silver, and are formed on the upper conductive film 13 or the lower conductive film 26 by ink jet printing or silk printing. The wiring 21b electrically connects the electrode 21a to the connection terminal 21c, the wiring 22b electrically connects the electrode 22a to the connection terminal 22c, the wiring 23b electrically connects the connection terminal 23c, and the wiring 24b electrically connects the connection terminal 24c. An end 23a of the wiring 23b is electrically connected to the electrode 11 of the upper substrate 10 through a wiring (not illustrated), and an end 24a of the wiring 24b is electrically connected to the electrode 12 of the upper substrate 10 through a wiring (not illustrated). In FIG. 1D, the bonding position of the FPC 40 is indicated by a chain line.

As illustrated in FIG. 2B, a lower conductive film 26 is formed on a surface 20a of the lower substrate 20 facing the upper substrate 10. The lower substrate 20 is made of glass or the like, and the lower conductive film 26 is made of indium tin oxide (ITO) or the like. The electrodes 21a and 22a, the wiring 24b, and the wiring 21b are formed on the lower conductive film 26 in the decoration region 2. The lower conductive film 26 between the electrode 22a and the wiring 24b and between the wiring 24b and the wiring 21b is removed by etching patterns 25. As indicated by the dotted lines in FIGs. 1C and 1D, the lower conductive film 26 between the electrode 12 and the wiring 21b, between the connection terminals 23c and 22c, between the connection terminals 22c and 24c, between the connection terminals 24c and 21c, a position surrounding the wiring 23b, and a position surrounding the wiring 24b are removed by the etching patterns 25.

As illustrated in FIG. 2C, an adhesive layer 30 is provided between the decoration layer 14 and the lower conductive film 26 in the decoration region 2. The adhesive layer 30 is formed to cover the upper surface and the side surface of each of the electrodes and the wirings. In FIG. 2C, the adhesive layer 30 is formed so as to cover the upper surface and the side surface of the electrode 21a and a part of the side surface and the upper surface of the wiring 22b. The adhesive layer 30 is an acrylic or epoxy insulating adhesive, but may be, for example, a PET (polyethylene terephthalate) film having a double-sided tape attached to the upper and lower surfaces thereof. The adhesive layer 30 electrically insulates the decoration layer 14 and the lower conductive film 26.

An anisotropic conducting film (ACF) described later is disposed between the FPC 40 and a part of the upper surface of the wiring 22b, and the FPC 40 is thermocompression-bonded by a crimping machine (not illustrated), whereby the FPC 40 is fixed to a part of the upper surface of the wiring 22b.

A space 31 is formed between the upper conductive film 13 and the lower conductive film 26 in the operation region 1. Spacers (not illustrated) may be provided in the space 31.

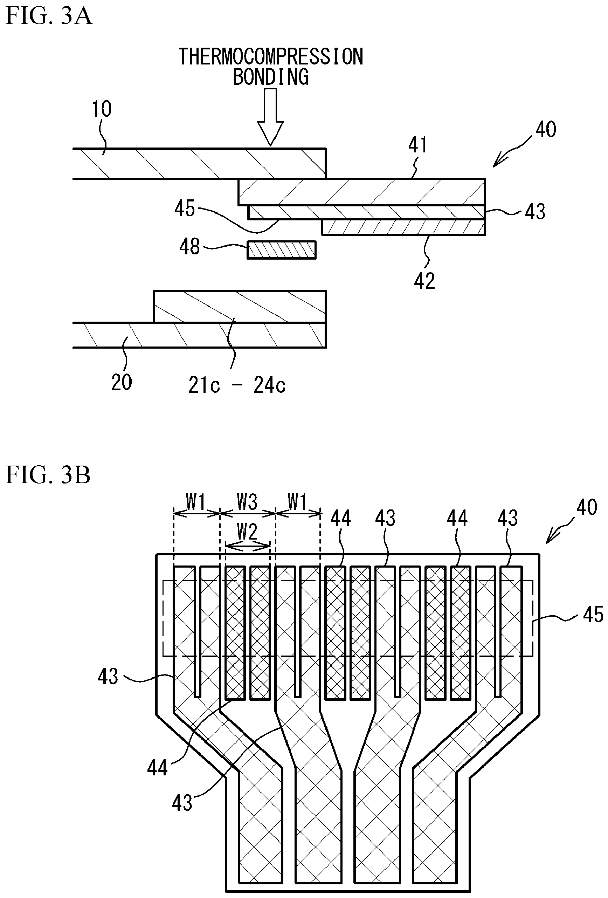

FIG. 3A is a diagram illustrating a state where the FPC 40 is connected to the connection terminals 21c to 24c, and FIG. 3B is a configuration diagram of the FPC 40.

As illustrated in FIG. 3A, the FPC 40 includes a base film 41, a cover lay 42, and a wiring pattern 43 interposed between the base film 41 and the cover lay 42. The base film 41 is, for example, a PET film or a polyimide film having an insulating property. The cover lay 42 protects the wiring pattern 43 and is made of, for example, an epoxy resin, a urethane resin, a PET film or a polyimide film. A part of the wiring pattern 43, i.e., a bonding surface 45 of the FPC 40 is exposed from the cover lay 42 so as to be connected to the connection terminals 21c to 24c through an anisotropic conducting film (ACF) 48. The FPC 40 is fixed to the upper surface of the connection terminals 21c to 24c by thermo-compression bonding the FPC 40 from above the upper substrate 10 by the crimping machine (not illustrated).

As illustrated in FIG. 3B, the FPC 40 has a plurality of wiring patterns 43 electrically connected to the plurality of connection terminals 21c to 24c, and a plurality of first dummy patterns 44 separated from the wiring patterns 43 and arranged between the wiring patterns 43. The first dummy pattern 44 has a thickness substantially the same as the thickness of the wiring pattern 43. The term "substantially the same" means that a difference in manufacturing error is allowed.

The wiring pattern 43 is a wiring pattern of a metal such as silver or copper. The first dummy pattern 44 is insulated from the wiring pattern 43. The first dummy pattern 44 is made of the same material as the wiring pattern 43 (for example, a metal such as silver or copper) or an insulating material different from the wiring pattern 43 (for example, a PET film, a polyimide film, or a resin). When the first dummy pattern 44 is made of the same material as the wiring pattern 43, the first dummy pattern 44 and the wiring pattern 43 can be formed by the same process, and therefore the manufacturing process of the FPC 40 can be simplified. The number of the wiring patterns 43 and the number of the first dummy patterns 44 are not limited to the example of FIG. 3B.

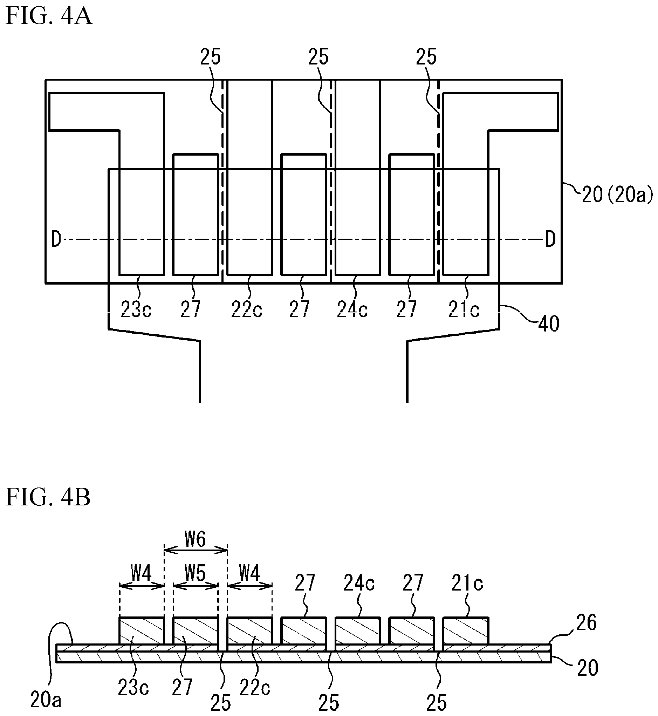

A width W1 of the wiring pattern 43 is substantially the same as a width W4 (see FIG. 4B) of each of the plurality of connection terminals 21c to 24c. A width W2 of the first dummy pattern 44 is substantially the same as a width W5 (see FIG. 4B) of each of second dummy patterns 27 described later. An interval W3 between the two wiring patterns 43 is substantially the same as an interval W6 (see FIG. 4B) between two connection terminals (for example, the connection terminals 23c and 22c). In this way, by making the width W1 and the width W4 substantially the same as each other, the width W2 and the width W5 substantially the same as each other, and the interval W3 and the interval W6 substantially the same as each other, the plurality of wiring patterns 43 of the FPC 40 can be fixed to the connection terminals 21c to 24c without positional deviation.

As illustrated in FIG. 3B, since the first dummy pattern 44 having a thickness substantially the same as that of the wiring pattern 43 is arranged between the wiring patterns 43 to ensure the flatness of the FPC 40, even if the FPC 40 is arranged between the upper substrate 10 and the lower substrate 20 and thermocompression bonding is performed, deformation of the upper substrate 10 can be suppressed. This can suppress the appearance of the touch panel 100 from being deteriorated by the press-bonded marks. Further, since the first dummy pattern 44 is separated from the wiring pattern 43, it is possible to prevent the first dummy pattern 44 and the wiring pattern 43 from being short-circuited.

If an interval between the first dummy pattern 44 and the adjacent wiring pattern 43 is smaller than 5% of the distance W3 between two wiring patterns, a short circuit may occur. If the interval between the first dummy pattern 44 and the adjacent wiring pattern 43 is larger than 20% of the distance W3 between the two wiring patterns, the flatness of the FPC 40 may not be ensured by thermocompression bonding. Therefore, the interval between the first dummy pattern 44 and the adjacent wiring pattern 43 is preferably 5% or more and 20% or less, and more preferably 10% or more and 15% or less of the interval W3 between the two wiring patterns 43. This prevents a short circuit between the first dummy pattern 44 and the wiring pattern 43 and ensures the flatness of the FPC 40.

FIG. 4A is a configuration diagram of the vicinity of the connection terminals 21c to 24c of the lower substrate 20, and FIG. 4B is a cross-sectional view taken along a line D-D of FIG. 4A.

As illustrated in FIGs. 4A and 4B, the surface 20a of the lower substrate 20 facing the upper substrate 10 has the plurality of connection terminals 21c to 24c electrically connected to the plurality of wiring patterns 43 of the FPC 40, and the plurality of second dummy patterns 27 separated from the connection terminals 21c to 24c and arranged between the connection terminals 21c to 24c. The second dummy pattern 27 has a thickness substantially the same as that of each of the plurality of connection terminals 21c to 24c. The term "substantially the same" means that a difference in manufacturing error is allowed. The FPC 40 is connected to the plurality of second dummy patterns 27 and the plurality of connection terminals 21c to 24c.

The second dummy patterns 27 is made of the same material as the connection terminals 21c to 24c (for example, metal paste of copper or silver) or an insulating material different from the connection terminals 21c to 24c (for example, PET film or resin). When the second dummy patterns 27 are made of the same material as the connection terminals 21c to 24c, the second dummy patterns 27 and the connection terminals 21c to 24c can be formed by the same process, and therefore the manufacturing process of the lower substrate 20 can be simplified. The number of connection terminals and the number of second dummy patterns 27 are not limited to those illustrated in FIGs. 4A and 4B.

The lower conductive film 26 between the connection terminals 23c and 22c, between the connection terminals 22c and 24c, and between the connection terminals 24c and 21c is removed by the etching patterns 25.

As illustrated in FIGs. 4A and 4B, since the second dummy patterns 27 each having a thickness substantially the same as that of each of the connection terminals 21c to 24c are arranged between the connection terminals 21c to 24c to ensure flatness of the bonding surface of the lower substrate 20 with respect to the FPC 40, the deformation of the upper substrate 10 can be suppressed even when the FPC 40 is arranged between the upper substrate 10 and the lower substrate 20 and thermocompression bonding is performed. This can suppress the appearance of the touch panel 100 from being deteriorated by the press-bonded marks. In particular, by adopting the configuration of FIG. 3B and the configuration of FIGs. 4A and 4B, the flatness of both the bonding surface of the FPC 40 and the bonding surface of the lower substrate 20 is ensured, and therefore the deformation of the upper substrate 10 due to thermocompression bonding can be further suppressed.

Further, since the second dummy patterns 27 are separated from the connection terminals 21c to 24c, it is possible to prevent the second dummy pattern 27 and the connection terminals 21c to 24c from being short-circuited.

When an interval between the second dummy pattern 27 and each of the adjacent connection terminals 21c to 24c is smaller than 5% of the interval W6 between the two connection terminals, a short circuit may occur. If the interval between the second dummy pattern 27 and each of the adjacent connection terminals 21c to 24c is larger than 20% of the interval W6 between the two connection terminals, non-flatness of the bonding surface of the lower substrate 20 may be ensured by thermocompression bonding. Therefore, the interval between the second dummy pattern 27 and each of the adjacent connection terminals 21c to 24c is preferably 5% or more and 20% or less, and more preferably 10% or more and 15% or less, of the interval W6 between the two connection terminals. This prevents short-circuiting between the second dummy pattern 27 and each of the connection terminals 21c to 24c and ensures flatness of the bonding surface of the lower substrate 20.

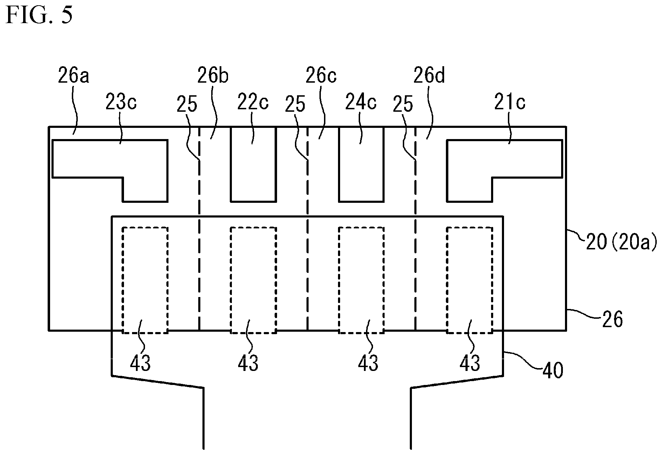

FIG. 5 is a configuration diagram of a modification of the lower substrate 20 in the vicinity of the connection terminals 21c to 24c. In FIG. 5, the plurality of second dummy patterns 27 are not present between the plurality of connection terminals 21c to 24c. When the plurality of second dummy patterns 27 are not present between the connection terminals 21c to 24c, and the FPC 40 is physically connected to the connection terminals 21c to 24c, a part of the FPC 40 drops between the connection terminals 21c to 24c, and the press-bonded marks are formed on the upper substrate 10 by thermocompression bonding.

In FIG. 5, the lower conductive film 26 is formed on the surface 20a of the lower substrate 20 facing the upper substrate 10, and the plurality of connection terminals 21c to 24c are formed on the lower conductive film 26. The lower conductive film 26 between the plurality of connection terminals 21c to 24c is separated into a plurality of lower conductive films 26a to 26d by the etching patterns 25, and the plurality of wiring patterns 43 of the FPC 40 are physically connected to the plurality of lower conductive films 26a to 26d, respectively.

As described above, the plurality of wiring patterns 43 of the FPC 40 are not physically connected to the connection terminals 21c to 24c, respectively, but are electrically connected to the connection terminals 21c to 24c, respectively, through the lower conductive films 26a to 26d separated by the etching patterns 25. Therefore, since the FPC 40 is connected to the flat lower conductive films 26a to 26d and electrically connected to the connection terminals 21c to 24c, the flatness of the FPC 40 can be easily ensured. Further, it is possible to suppress the appearance of the touch panel 100 from being deteriorated by the press-bonded marks. If the first dummy patterns 44 between the wiring patterns 43 of FIG. 3B are provided in the FPC 40 of FIG. 5, it becomes easier to ensure flatness.

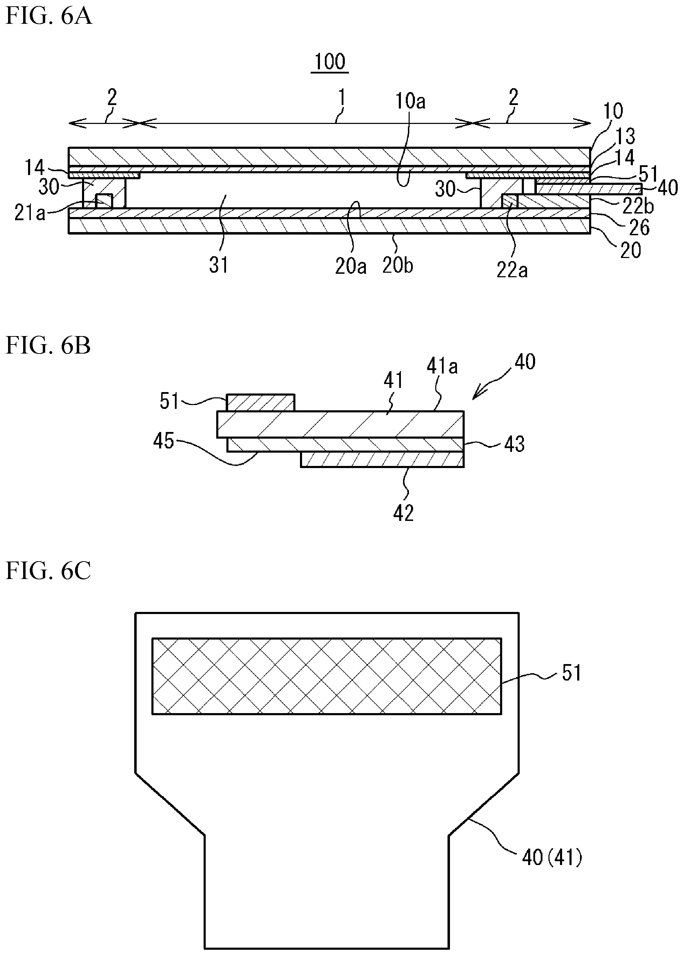

FIG. 6A is a cross-sectional view of a modification of the touch panel taken along a line C-C of FIG. 1D. FIG. 6B is a cross-sectional view of a modification of the FPC 40, and FIG. 6C is a plan view of the base film 41 of the FPC 40.

As illustrated in FIG. 6A, the touch panel 100 may include a reinforcing member 51 for reinforcing the rigidity of the upper substrate 10 between the surface 10a of the upper substrate 10 facing the lower substrate 20 and the FPC 40. The reinforcing member 51 is formed on either the surface of the decoration layer 14 near the lower substrate 20 or a surface 41a of the base film 41 opposite to the wiring pattern 43 of the FPC 40. The reinforcing member 51 is, for example, a metal film such as a copper foil, a PET film, a polyimide film, or a resin.

For example, by providing the reinforcing member 51 on the surface of the decoration layer 14 near the lower substrate 20, the rigidity of the upper substrate 10 can be increased, and the deformation of the upper substrate 10 due to thermocompression bonding can be suppressed. This can prevent the appearance of the touch panel 100 from being deteriorated by the press-bonded marks.

As illustrated in FIGs. 6B and 6C, the reinforcing member 51 may be provided on the surface 41a of the base film 41 opposite to the wiring pattern 43 of the FPC 40. Also in this case, the rigidity of the upper substrate 10 can be increased, and the deformation of the upper substrate 10 due to thermocompression bonding can be suppressed.

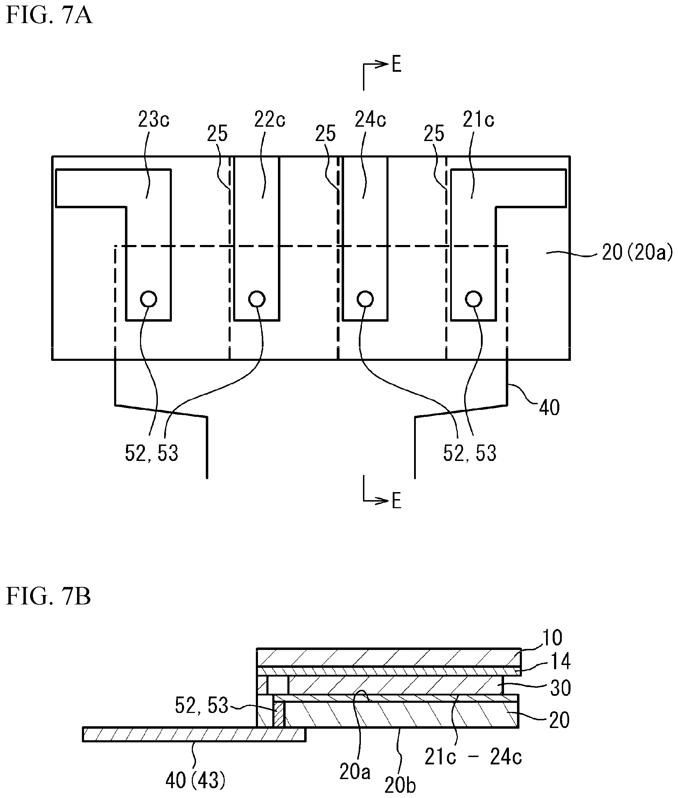

FIG. 7A is a configuration diagram of the vicinity of the connection terminals 21c to 24c of the lower substrate 20, and FIG. 7B is a cross-sectional view of the touch panel taken along a line E-E of FIG. 7A. In the cross-sectional view of FIG. 7B, the upper conductive film 13 and the lower conductive film 26 are not illustrated.

As illustrated in FIGs. 7A and 7B, a part (bonding surface) of the FPC 40 is not disposed between the upper substrate 10 and the lower substrate 20, but is fixed to a surface 20b of the lower substrate 20 below the decoration layer 14 and opposite to the upper substrate 10. Each of the connection terminals 21c to 24c and the lower substrate 20 includes a through hole 52 and a conductor 53 inserted into the through hole 52. The conductor 53 is made of, for example, a metal paste of copper or silver or a conductive resin. Each of the connection terminals 21c to 24c is electrically connected to the wiring pattern 43 of the FPC 40 through the conductor 53. The conductor 53 is connected to the wiring pattern 43 of the FPC 40 by using a conductive adhesive.

In the case of FIGs. 7A and 7B, since the FPC 40 is not disposed between the upper substrate 10 and the lower substrate 20 and is not thermocompression-bonded, the FPC 40 may have the first dummy pattern 44.or need not have the first dummy pattern 44.

According to the configuration of FIGs. 7A and 7B, since a part (bonding surface) of the FPC 40 is arranged on the surface 20b of the lower substrate 20 opposite to the upper substrate 10 and is not arranged between the upper substrate 10 and the lower substrate 20 to perform thermocompression bonding, the deformation of the upper substrate 10 due to thermocompression bonding can be suppressed. This can suppress the appearance of the touch panel 100 from being deteriorated by the press-bonded marks.

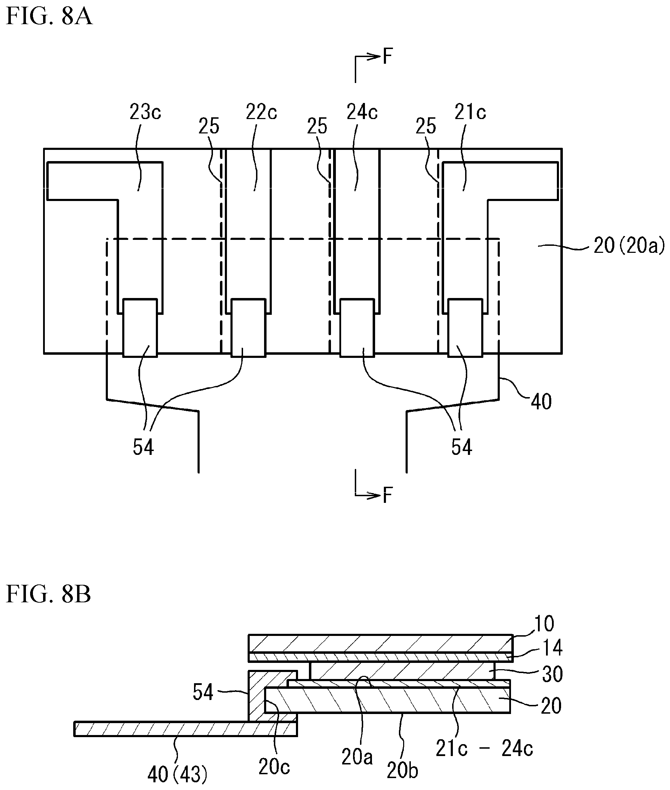

FIG. 8A is a configuration diagram of the vicinity of the connection terminals 21c to 24c of the lower substrate 20, and FIG. 8B is a cross-sectional view of the touch panel taken along a line F-F in FIG. 8A. In the cross-sectional view of FIG. 8B, the upper conductive film 13 and the lower conductive film 26 are not illustrated.

As illustrated in FIGs. 8A and 8B, the touch panel 100 may include conductors 54 each sandwiching each of the plurality of connection terminals 21c to 24c, a part of the surface 20a of the lower substrate 20 facing the upper substrate 10, an end surface 20c of the lower substrate 20, and a part of the surface 20b of the lower substrate 20 opposite to the upper substrate 10. The conductor 54 may be, for example, a conductive clip, a conductive resin, or a printed copper or silver metal paste.

The FPC 40 is disposed on a part of the conductor 54 located on the surface 20b of the lower substrate 20 opposite to the upper substrate 10. In the case where the end face 20c of the lower substrate 20 has a sufficient thickness for connecting the FPC 40, the FPC 40 may be disposed on a part of the conductor 54 located on the end face 20c of the lower substrate 20.

In the case of FIGs. 8A and 8B, since the FPC 40 is not disposed between the upper substrate 10 and the lower substrate 20 and is not thermocompression-bonded, the FPC 40 may have the first dummy pattern 44 or need not have the first dummy pattern 44.

According to the configuration of FIGs. 8A and 8B, since the part (bonding surface) of the FPC 40 is disposed on the part of the conductor 54 located on the surface 20b of the lower substrate 20 opposite to the upper substrate 10 and is not disposed between the upper substrate 10 and the lower substrate 20 to perform thermocompression bonding, deformation of the upper substrate 10 due to thermocompression bonding can be suppressed. This can suppress the appearance of the touch panel 100 from being deteriorated by the press-bonded marks.

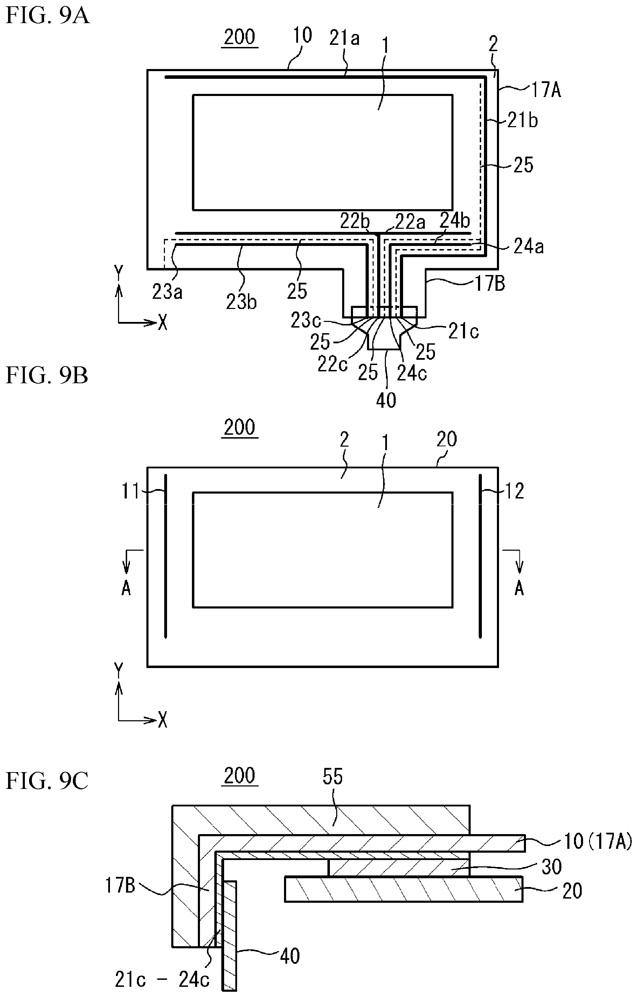

FIG. 9A is a configuration diagram of an upper substrate included in a touch panel according to a modification, FIG. 9B is a configuration diagram of a lower substrate included in the touch panel according to the modification, and FIG. 9C is a cross-sectional view of a part of the touch panel according to the modification.

The upper substrate 10 and the lower substrate 20 of a touch panel 200 according to the modification are formed by reversing the patterns of the electrodes and the wirings of the upper substrate 10 and the lower substrate 20 of the touch panel 100 illustrated in FIGs. 1B and 1C. Therefore, the upper substrate 10 in FIG. 9A includes the electrodes 21a and 22a, the wirings 21b to 24b, and the connection terminals 21c to 24, and the lower substrate 20 in FIG. 9B includes the electrodes 11 and 12.

As illustrated in FIG. 9A, the upper substrate 10 of the touch panel 200 according to the modification includes a main body 17A facing the lower substrate 20, and an extension portion 17B extending from the main body 17A, fixed to a housing 55 by an adhesive or a double-sided tape, and covered by the housing 55. The wirings 21b to 24b provided on the main body 17A are extended to the extension portion 17B, and the connection terminals 21c to 24c are provided at the end of the extension portion 17B opposite to the main body 17A. As illustrated in FIGs. 9A and 9C, the FPC 40 is disposed in the extension portion 17B, is fixed by a conductive adhesive (not illustrated), and is electrically connected to the connection terminals 21c to 24c. For example, the electrodes 21a and 22a, the wirings 21b to 24b, and the connection terminals 21c to 24 are covered with the housing 55.

In the case of FIG. 9C, since the FPC 40 is not disposed between the upper substrate 10 and the lower substrate 20 and is not thermocompression-bonded, the FPC 40 may have the first dummy pattern 44 or need not have the first dummy pattern 44.

According to the configuration of FIGs. 9A to 9C, since the FPC 40 is disposed on the extension portion 17B of the upper substrate 10 and the FPC 40 is not disposed between the upper substrate 10 and the lower substrate 20 to perform thermocompression bonding, the deformation of the upper substrate 10 due to thermocompression bonding can be suppressed. This can suppress the appearance of the touch panel 200 from being deteriorated by the press-bonded marks. Even if a bonding portion between the FPC 40 and the extension portion 17B is deformed, the bonding portion between the FPC 40 and the extension portion 17B is covered with the housing 55, so that the appearance of the touch panel 200 can be suppressed from being deteriorated.

As described above, according to the present embodiment, the touch panel 100 includes the upper substrate 10 and the lower substrate 20 that are arranged to face each other with a space therebetween, the plurality of connection terminals 21c to 24c provided on the surface 20a of the lower substrate 20 facing the upper substrate 10, and the FPC 40 that is arranged in the decoration region 2 and between the upper substrate 10 and the lower substrate 20 and has the plurality of wiring patterns 43 electrically connected to the plurality of connection terminals 21c to 24c, respectively. Further, the touch panel 100 includes at least one of the first dummy pattern 44 that is separated from the plurality of wiring patterns 43, is arranged between the plurality of wiring patterns 43, and has a thickness substantially the same as the thickness of each of the plurality of wiring patterns 43, and the second dummy pattern 27 that is separated from the plurality of connection terminals 21c to 24c, is arranged between the plurality of connection terminals 21c to 24c, and has a thickness substantially the same as the thickness of each of the plurality of connection terminals 21c to 24c.

According to this configuration, at least one of the first dummy pattern 44 having a thickness substantially the same as that of the wiring pattern 43 between the wiring patterns 43 and the second dummy pattern 27 having a thickness substantially the same as that of each of the connection terminals 21c to 24c between the connection terminals 21c to 24c is arranged to ensure the flatness of the FPC 40. Therefore, even when the FPC 40 is arranged between the upper substrate 10 and the lower substrate 20 and thermocompression bonding is performed, the deformation of the upper substrate 10 can be suppressed. This can prevent the appearance of the touch panel 100 from being deteriorated by the press-bonded marks.

The touch panel 100 includes the upper substrate 10 and the lower substrate 20 that are arranged to face each other with a space therebetween, the plurality of connection terminals 21c to 24c provided on the surface 20a of the lower substrate 20 facing the upper substrate 10, and the FPC 40 that is arranged in the decoration region 2 and between the upper substrate 10 and the lower substrate 20, and has a plurality of wiring patterns 43 electrically connected to the plurality of connection terminals 21c-24c, respectively. The lower conductive film 26 is formed on the surface 20a of the lower substrate 20 facing the upper substrate 10, the plurality of connection terminals 21c to 24c are formed in the decoration region 2 and on the conductive film 26, the lower conductive film 26 between the plurality of connection terminals 21c to 24c is separated into a plurality of lower conductive films 26a to 26d, and the plurality of wiring patterns 43 are connected to the connection terminals 21c to 24c through the plurality of lower conductive films 26a to 26d, respectively.

According to this configuration, the FPC 40 is connected to the flat lower conductive films 26a to 26d and electrically connected to the connection terminals 21c to 24c, so that the flatness of the FPC 40 can be easily ensured. Further, it is possible to suppress the appearance of the touch panel 100 from being deteriorated by the press-bonded marks.

The touch panel 100 may include the upper substrate 10 and the lower substrate 20 that are arranged to face each other with a space therebetween, the plurality of connection terminals 21c to 24c provided on the surface 20a of the lower substrate 20 facing the upper substrate 10, and the FPC 40 that is arranged in the decoration region 2 and on the surface 20b of the lower substrate 20 opposite to the upper substrate 10, and has the plurality of wiring patterns 43 electrically connected to the connection terminals 21c to 24c. Each of the lower substrate 20 and the plurality of connection terminals 21c to 24c may include the through hole 52 and the conductor 53 inserted into the through hole 52, and each of the plurality of connection terminals 21c to 24c may be electrically connected to each of the plurality of wiring patterns 43 through the conductor 53.

According to this configuration, since a part (bonding surface) of the FPC 40 is arranged on the surface 20b of the lower substrate 20 opposite to the upper substrate 10 and is not arranged between the upper substrate 10 and the lower substrate 20 to perform thermocompression bonding, the deformation of the upper substrate 10 due to thermocompression bonding can be suppressed. This can prevent the appearance of the touch panel 100 from being deteriorated by the press-bonded marks.

The touch panel 100 may include the upper substrate 10 and the lower substrate 20 that are arranged to face each other with a space therebetween, the plurality of connection terminals 21c to 24c provided on the surface 20a of the lower substrate 20 facing the upper substrate 10, the FPC 40 that is arranged in the decoration region 2 and has the plurality of wiring patterns 43 electrically connected to the plurality of connection terminals 21c-24c, respectively, and the conductor 54 sandwiching one of the plurality of connection terminals 21c to 24, a part of the surface 20a of the lower substrate 20 facing the upper substrate 10, the end surface 20c of the lower substrate 20, and a part of the surface 20b of the lower substrate 20 opposite to the upper substrate 10. The FPC 40 may be arranged on a part of the conductor 54 located on the surface 20b of the lower substrate 20 opposite the upper substrate 10.

According to this configuration, since a part (bonding surface) of the FPC 40 is arranged on a part of the conductor 54 located on the surface 20b of the lower substrate 20 opposite to the upper substrate 10 and is not disposed between the upper substrate 10 and the lower substrate 20 to perform thermocompression bonding, the deformation of the upper substrate 10 due to thermocompression bonding can be suppressed. This can prevent the appearance of the touch panel 100 from being deteriorated by the press-bonded marks.

The touch panel 200 includes the upper substrate 10 and the lower substrate 20 that are arranged to face each other with a space therebetween, the plurality of connection terminals 21c to 24c provided on the surface 20a of the lower substrate 20 facing the upper substrate 10, and the FPC 40 having the plurality of wiring patterns 43 that are electrically connected to the plurality of connection terminals 21c to 24c, respectively. The upper substrate 10 includes the main body 17A facing the lower substrate 20, and the extension portion 17B that extends from the main body 17A, is fixed to the housing 55, and is covered by the housing 55. The FPC 40 is arranged on the extension portion 17B.

According to this configuration, the FPC 40 is not arranged on the extension portion 17B of the upper substrate 10 and the FPC 40 is not disposed between the upper substrate 10 and the lower substrate 20 to perform thermocompression bonding, so that the deformation of the upper substrate 10 due to thermocompression bonding can be suppressed. This can suppress the appearance of the touch panel 200 from being deteriorated by the press-bonded marks.

The present specification also discloses the following technique.

### (Supplementary Note 1)

A touch panel having an operation region for receiving operation input and a decoration region for not receiving the operation input, the touch panel comprising:
a first substrate and a second substrate that are arranged to face each other with a space therebetween;
a plurality of connection terminals provided on a surface of the second substrate facing the first substrate;
a wiring substrate arranged in the decoration region and between the first substrate and the second substrate, the wiring substrate having a plurality of wiring patterns electrically connected to the plurality of connection terminals, respectively; and
at least one of a first dummy pattern that is separated from the plurality of wiring patterns, is arranged between the plurality of wiring patterns, and has a thickness substantially the same as a thickness of each of the plurality of wiring patterns, and a second dummy pattern that is separated from the plurality of connection terminals, is arranged between the plurality of connection terminals, and has a thickness substantially the same as a thickness of each of the plurality of connection terminals.

### (Supplementary Note 2)

The touch panel according to Supplementary Note 1, further comprising
a reinforcing member provided between a surface of the first substrate facing the second substrate and the wiring substrate.

### (Supplementary Note 3)

A touch panel having an operation region for receiving operation input and a decoration region for not receiving the operation input, the touch panel comprising: a first substrate and a second substrate that are arranged to face each other with a space therebetween;
a plurality of connection terminals provided on a surface of the second substrate facing the first substrate; and
a wiring substrate arranged in the decoration region and between the first substrate and the second substrate, the wiring substrate having a plurality of wiring patterns electrically connected to the plurality of connection terminals, respectively;
wherein a conductive film is formed on the surface of the second substrate facing the first substrate, the plurality of connection terminals are formed in the decoration region and on the conductive film, the conductive film between the plurality of connection terminals is separated into a plurality of conductive films, and the plurality of wiring patterns are connected to the connection terminals through the plurality of conductive films, respectively.

### (Supplementary Note 4)

The touch panel according to Supplementary Note 3, further comprising
a reinforcing member provided between a surface of the first substrate facing the second substrate and the wiring substrate.

### (Supplementary Note 5)

A touch panel having an operation region for receiving operation input and a decoration region for not receiving the operation input, the touch panel comprising:
a first substrate and a second substrate that are arranged to face each other with a space therebetween;
a plurality of connection terminals provided on a surface of the second substrate facing the first substrate; and
a wiring substrate arranged in the decoration region and on a surface of the second substrate opposite to the first substrate, the wiring substrate having a plurality of wiring patterns electrically connected to the plurality of connection terminals, respectively;
wherein each of the plurality of connection terminals and the second substrate includes a through hole and a conductor inserted into the through hole, and each of the plurality of connection terminals is electrically connected to each of the plurality of wiring patterns through the conductor.

### (Supplementary Note 6)

A touch panel having an operation region for receiving operation input and a decoration region for not receiving the operation input, the touch panel comprising:
a first substrate and a second substrate that are arranged to face each other with a space therebetween;
a plurality of connection terminals provided on a surface of the second substrate facing the first substrate;
a wiring substrate arranged in the decoration region, the wiring substrate having a plurality of wiring patterns electrically connected to the plurality of connection terminals, respectively; and
a conductor sandwiching one of the plurality of connection terminals, a part of the surface of the second substrate facing the first substrate, an end face of the second substrate, and a part of a surface of the second substrate opposite to the first substrate;
wherein the wiring substrate is arranged on a part of the conductor.

### (Supplementary Note 7)

A touch panel comprising:
a first substrate and a second substrate that are arranged to face each other with a space therebetween;
a plurality of connection terminals provided on a surface of the first substrate facing the second substrate; and
a wiring substrate having a plurality of wiring patterns electrically connected to the plurality of connection terminals, respectively;
wherein the first substrate includes a main body facing the second substrate, and an extension portion that extends from the main body, is fixed to a housing, and is covered by the housing, and
the wiring substrate is arranged on the extension portion.

All examples and conditional language provided herein are intended for the purposes of aiding the reader in understanding the invention and the concepts contributed by the inventor to further the art, and are not to be construed as limitations to such specifically recited examples and conditions, nor does the organization of such examples in the specification relate to a showing of the superiority and inferiority of the invention. Although one or more embodiments of the present invention have been described in detail, it should be understood that the various changes, substitutions, and alterations could be made hereto without departing from the spirit and scope of the invention.

## Claims

1. A touch panel (100) having an operation region (1) for receiving operation input and a decoration region (2) for not receiving the operation input, the touch panel comprising:
a first substrate (10) and a second substrate (20) that are arranged to face each other with a space therebetween;
a plurality of connection terminals (21c to 24c) provided on a surface (20a) of the second substrate facing the first substrate;
a wiring substrate (40) arranged in the decoration region and between the first substrate and the second substrate, the wiring substrate having a plurality of wiring patterns (43) electrically connected to the plurality of connection terminals, respectively; and
at least one of a first dummy pattern (44) that is separated from the plurality of wiring patterns, is arranged between the plurality of wiring patterns, and has a thickness substantially the same as a thickness of each of the plurality of wiring patterns, and a second dummy pattern (27) that is separated from the plurality of connection terminals, is arranged between the plurality of connection terminals, and has a thickness substantially the same as a thickness of each of the plurality of connection terminals.

2. The touch panel according to claim 1, further comprising
a reinforcing member (51) provided between a surface of the first substrate facing the second substrate and the wiring substrate.

3. A touch panel (100) having an operation region (1) for receiving operation input and a decoration region (2) for not receiving the operation input, the touch panel comprising:
a first substrate (10) and a second substrate (20) that are arranged to face each other with a space therebetween;
a plurality of connection terminals (21c to 24c) provided on a surface (20a) of the second substrate facing the first substrate; and
a wiring substrate (40) arranged in the decoration region and between the first substrate and the second substrate, the wiring substrate having a plurality of wiring patterns (43) electrically connected to the plurality of connection terminals, respectively;
wherein a conductive film (26) is formed on the surface of the second substrate facing the first substrate, the plurality of connection terminals are formed in the decoration region and on the conductive film, the conductive film between the plurality of connection terminals is separated into a plurality of conductive films (26a to 26d), and the plurality of wiring patterns are connected to the connection terminals through the plurality of conductive films, respectively.

4. The touch panel according to claim 3, further comprising
a reinforcing member (51) provided between a surface of the first substrate facing the second substrate and the wiring substrate.

5. A touch panel (100) having an operation region (1) for receiving operation input and a decoration region (2) for not receiving the operation input, the touch panel comprising:
a first substrate (10) and a second substrate (20) that are arranged to face each other with a space therebetween;
a plurality of connection terminals (21c to 24c) provided on a surface (20a) of the second substrate facing the first substrate; and
a wiring substrate (40) arranged in the decoration region and on a surface (20b) of the second substrate opposite to the first substrate, the wiring substrate having a plurality of wiring patterns (43) electrically connected to the plurality of connection terminals, respectively;
wherein each of the plurality of connection terminals and the second substrate includes a through hole (52) and a conductor (53) inserted into the through hole, and each of the plurality of connection terminals is electrically connected to each of the plurality of wiring patterns through the conductor.

6. A touch panel (100) having an operation region (1) for receiving operation input and a decoration region (2) for not receiving the operation input, the touch panel comprising:
a first substrate (10) and a second substrate (20) that are arranged to face each other with a space therebetween;
a plurality of connection terminals (21c to 24c) provided on a surface (20a) of the second substrate facing the first substrate;
a wiring substrate (40) arranged in the decoration region, the wiring substrate having a plurality of wiring patterns (43) electrically connected to the plurality of connection terminals, respectively; and
a conductor (54) sandwiching one of the plurality of connection terminals, a part of the surface of the second substrate facing the first substrate, an end face of the second substrate, and a part of a surface of the second substrate opposite to the first substrate;
wherein the wiring substrate is arranged on a part of the conductor.

7. A touch panel (200) comprising:
a first substrate (10) and a second substrate (20) that are arranged to face each other with a space therebetween;
a plurality of connection terminals (21c to 24c) provided on a surface (20a) of the first substrate facing the second substrate; and
a wiring substrate (40) having a plurality of wiring patterns (43) electrically connected to the plurality of connection terminals, respectively;
wherein the first substrate includes a main body (17A) facing the second substrate, and an extension portion (17B) that extends from the main body, is fixed to a housing (55), and is covered by the housing, and
the wiring substrate is arranged on the extension portion.
